# EUROPÄISCHE PATENTANMELDUNG

(11) **EP 0 917 177 A1**
(43) Veröffentlichungstag der Anmeldung: **19.05.1999**
(21) Anmeldenummer: 97120124.9
(22) Anmeldetag: 17.11.1997
(51) Int. Cl.: H01J 37/04, H01J 37/28

(54) **Korpuskularstrahlgerät**

(71) Anmelder: ICT Integrated Circuit Testing Gesellschaft für Halbleiterprüftechnik mbH, 85551 Heimstetten (DE)
(72) Erfinder: Feuerbaum, Hans-Peter, Dr., 81739 München (DE); Winkler, Dieter, Dr., 81739 München (DE); Degenhardt, Ralf, Dr., 85609 Aschheim (DE); Munack, Harry, Dr., 85551 Heimstetten (DE)
(74) Vertreter: DIEHL GLAESER HILTL & PARTNER

(57) **Zusammenfassung**

Die Erfindung lehrt ein Korpuskularstrahlgerät (1), bei dem die Primärkorpuskeln (PE) schräg auf die optische Achse (A) zugeführt werden. Eine Ablenkeinrichtung (56) führt den Primärstrahl (PE) in die optische Achse (A) zurück. Die Ablenkeinrichtung (56) wird gleichzeitig zur besseren Trennung der durch das Auftreffen des Primärstrahls (PE) auf die Probe (26) entstehenden Sekundärkorpuskeln (SE) von denen Primärkorpuskeln (PE) ausgenutzt. Dies bewirkt insgesamt eine Vereinfachung der Einrichtungen, die zur Trennung der Primärkorpuskeln von den Sekundärkorpuskeln erforderlich sind.

## Beschreibung

Die Erfindung betrifft ein Korpuskularstrahlgerät mit einer Quelle zur Erzeugung der Primärkorpuskeln im Primärstrahl, einer Probe, auf die der Strahl der Primärkorpuskeln, in einer Richtung, unter Erzeugung von Sekundärkorpuskeln, auftrifft, einer Teilchenoptik, um Korpuskeln von der Quelle auf die Probe zu lenken, und einem außerhalb des Strahlenganges für die Primärkorpuskeln angeordneten Detektor für Sekundärkorpuskeln von der Probe.

Ein solches Korpuskularstrahlgerät ist, insbesondere in der Form des Rasterelektronenmikroskopes, allgemein bekannt.

Die Detektion der Sekundärkorpuskeln, die über den zu untersuchenden Zustand der Probe Aufschluß geben, ist dabei besonders wichtig. Dazu müssen die Primärkorpuskeln (meistens Elektronen, deswegen wird, ohne daß damit eine Beschränkung beabsichtigt ist, nachfolgend auch häufig von Primärelektronen bzw. Sekundärelektronen gesprochen) von den Sekundärkorpuskeln getrennt werden. Dabei soll der Primärelektronenstrahl möglichst wenig beeinflußt werden, d. h., die Ortsauflösung des Systems soll nicht beeinträchtigt werden. Weiter sollen die Sekundärelektronen möglichst vollständig erfaßt werden.

Bei seitlich angebrachten Detektoren wurden bislang zwei Systeme verwendet. Bei dem einen wurde in der Probenkammer, d. h. zwischen Objektivlinse und Objekt/Probe, seitlich vom axial verlaufenden Primärelektronenstrahl, ein Detektor angebracht. Nachteilig daran ist, daß der Arbeitsabstand, das ist der Minimalabstand zwischen Objektivlinse und Objekt, um den Sekundärelektronendetektor vergrößert wird. Außerdem ist ein schwaches, seitwärts gerichtetes elektrisches Feld zur Ablenkung der Sekundärelektronen in Richtung des Detektors erforderlich. Beides wirkt sich negativ auf den kleinsten erreichbaren Durchmesser des Primärstrahls aus, der die Ortsauflösung bestimmt.

Der Detektor wird auch häufig oberhalb der Objektivlinse, insbesondere bei Objektivlinsen mit überlagerten elektrostatisch-magnetischen Feldern angebracht. Bei einem seitlich angebrachten Detektor werden dann die Sekundärelektronen mittels eines Wien-Filters (charakterisiert durch gekreuzte **E**- und **B**-Felder) von der optischen Achse zum Detektor hin abgelenkt. Jedoch erfordert der Wien-Filter einen erheblichen Aufwand und hat auch große Justierschwierigkeiten.

Die Erfindung schafft daher ein Korpuskularstrahlgerät der angegebenen Gattung, bei der bei einfachen Aufbau die Sekundärelektronen sicher von den Primärelektronen getrennt werden können und die Auflösung des Primärelektronenstrahls möglichst wenig beeinflußt wird.

Dies wird erfindungsgemäß erreicht durch Einrichtungen derart, daß der Primärstrahl schräg auf die optische Achse zuläuft, und eine Ablenkeinrichtung unterhalb des Detektors zum Ein- bzw. Rückführen des Primärstrahls in die Achse.

Bei der Verwendung von Begriffen wie "unterhalb" und "oberhalb" wird stets davon ausgegangen, daß die Quelle "oberhalb" der Probe angeordnet ist, wie dies meist in der Praxis der Fall ist.

Die erfindungsgemäße Lösung hat insbesondere folgende Vorteile: Die Schrägrichtung des Primärkorpuskelstrahls zur Achse macht eine Ablenkeinrichtung nötig. Diese kann jedoch sehr einfach, z. B. viel einfacher als ein Wien-Filter, aufgebaut sein. Diese Ablenkeinrichtung beeinflußt aber auch die Sekundärelektronen, und zwar im Sinne einer Trennung von Primärkorpuskeln und Sekundärkorpuskeln, unabhängig davon, ob die Ablenkeinrichtung magnetisch oder elektrostatisch ausgebildet ist, wie unten noch ausgeführt werden wird. Durch die (seitliche) Anordnung des Detektors in der Zielrichtung der durch die Ablenkeinrichtung beeinflußten Sekundärkorpuskeln können diese sicher und ohne großen Aufwand detektiert werden, während der Primärstrahl, insbesondere in Anbetracht der in der Praxis sehr kleinen Winkel, um die der Primärstrahl abgelenkt wird, praktisch nicht negativ beeinflußt wird.

Bevorzugt sind die Einrichtungen durch eine entsprechende Schrägstellung der Quelle und der Teilchenoptik vor der Ablenkeinrichtung verwirklicht. Wenn die Quelle und die nachfolgende Teilchenoptik (z. B. Kondensor usw.) vor der Ablenkeinrichtung um den gewünschten Winkel aus der normalerweise Quelle und Probe verbindenden Achse gekippt werden, wird auf einfache Weise ein Schrägauftreffen des Primärkorpuskelstrahles erreicht, welches Schrägauftreffen durch die erfindungsgemäße Ablenkeinrichtung mit den gewünschten Wirkungen, insbesondere auf den Sekundärkorpuskelstrahl, korrigiert wird.

Bevorzugt verläuft die Strahlrichtung zumindest eines Teils des Primärkorpuskelstrahls vor der Ablenkeinrichtung parallel versetzt zur optischen Achse und ist eine Auslenkeinrichtung zum Auslenken des Primärstrahls aus dieser Strahlrichtung schräg auf die optische Achse vorgesehen.

In dieser Ausführungsform werden also Quelle und nachfolgende Teilchenoptik (oder zumindest ein Teil davon) nicht gekippt, sondern parallel versetzt, und der dann ursprünglich zur Achse parallele Strahl wird durch eine hier als Auslenkeinrichtung bezeichnete Einrichtung (die sich von ihrer Art her nicht von der erfindungsgemäßen Ablenkeinrichtung unterscheiden muß) aus dieser parallelen Richtung schräg zur Achse auf die Achse hingelenkt. Diese Auslenkeinrichtung ist zwar eine zusätzliche Einrichtung, erfordert aber immer noch wesentlich weniger Aufwand als z. B. ein Wien-Filter und hat insbesondere den Vorteil, daß durch die, der durch die Ablenkeinrichtung bewirkten Ablenkung gerade entgegengesetzte, Auslenkung, durch jene Ablenkung möglicherweise entstehende Bildfehler (Aberrationen) kompensiert werden können.

Bevorzugt liegt die Richtung des Primärstrahls aus der Quelle im Wesentlichen in der optischen Achse, die durch die Objektivachse gegeben ist, und weisen die Einrichtungen eine erste Auslenkeinrichtung zum Auslenken des Primärstrahls aus der Achse und eine zweite Auslenkeinrichtung zum Rücklenken des Primärstrahls in Richtung der Achse auf.

Durch diese Anordnung bleibt einerseits der normale Aufbau des Rasterelektronenmikroskopes, bei dem Quelle und Probe im Wesentlichen in einer geraden Linie, der optischen Achse, übereinander angeordnet sind, erhalten. Durch das vorsehen von zwei Auslenkeinrichtungen, von denen die eine den Primärelektronenstrahl aus dieser Mittenachse auslenkt und die andere diese auf die Mittenachse hin zurücklenkt, wonach dann die Ablenkeinrichtung den Strahl in die Achse zurückführt, können durch geeignete Wahl der Parameter (Winkel, Abstände, elektrische und magnetische Felder) Bildfehler korrigiert werden. Ferner ist durch geeignete Wahl der Natur der Ablenkfelder eine noch bessere Trennung von Primär- und Sekundärkorpuskelstrahl möglich, wie unten noch ausgeführt werden wird.

Dadurch, daß in dieser Anordnung der Primärkorpuskelstrahl oberhalb und unterhalb der Gesamtauslenk- bzw. Ablenkeinrichtung in der Mittellinie und damit der optischen Achse verläuft, werden auch Abbildungsfehler, die sich durch etwaigen außeraxialen Verlauf in elektronenoptischen Elementen wie z. B. Kondensor oder Objektiv ergäben, unterdrückt.

Bevorzugt wirkt die (beim Vorhandensein zweier Auslenkeinrichtungen: erste) Auslenkeinrichtung und/oder (einzige oder zweite) Auslenkeinrichtung elektrostatisch.

Bevorzugt wirkt die (beim Vorhandensein zweier Auslenkeinrichtungen: erste) Auslenkeinrichtung und/oder (einzige oder zweite) Auslenkeinrichtung magnetisch.

Es sind also grundsätzlich alle Kombinationen und auch Überlagerungen von Auslenkfeldern denkbar, wobei einige, und auch einige Kombinationen, besondere Vorteile haben, wie noch ausgeführt werden wird. Selbstverständlich wird man darauf achten, daß die gewählten Kombinationen bzw. Überlagerungen einfach zu erzeugen sind und zum Beispiel nicht die Kompliziertheit eines Wien-Filters erreichen, dessen Verwendung bei einem gattungsgemäßen Gerät ja gerade vermieden werden soll.

Bevorzugt wirkt die Ablenkeinrichtung magnetisch und/oder elektrostatisch.

Bei einer magnetisch wirkenden Ablenkeinrichtung tritt eine besonders gute Trennung von Sekundär- und Primärstrahl in komplementäre Räume auf. Dies folgt aus dem Lorentz-Kraftgesetz, wonach die Sekundärpartikel aufgrund ihrer gegenüber den Primärpartikeln gerade entgegengesetzten Flugrichtung im Ablenksystem eine entgegengesetzt gerichtete Kraft erfahren, also in einen zum Halbraum des Primärelektronenstrahles komplementären Halbraum gelenkt werden, in dem selbstverständlich dann der Detektor an geeigneter Stelle angeordnet werden kann.

Ist die Ablenkeinrichtung hingegen elektrostatisch, werden die Sekundärkorpuskeln zwar in den durch den Primärkorpuskelstrahl bestimmten senkrechten Halbraum abgelenkt. Für die Sekundärelektronen ist der Ablenkwinkel jedoch größer, da der Ablenkwinkel in erster Näherung umgekehrt proportional zur Geschwindigkeit ist. Es ergibt sich daraus die richtungsmäßige und damit räumliche Trennung der Sekundärkorpuskeln von den Primärkorpuskeln.

Besonders bevorzugt ist die erste Auslenkeinrichtung magnetisch, die zweite Auslenkeinrichtung elektrostatisch und die Ablenkeinrichtung als magnetische Ablenkeinrichtung ausgebildet, wobei der Detektor für die Sekundärkorpuskeln oberhalb der zweiten Auslenkeinrichtung liegt. Wie erläutert wird durch eine magnetisch ausgebildete Ablenkeinrichtung der Sekundärkorpuskelstrahl in den zum vom Primärkorpuskelstrahl definierten komplementären Halbraum gelenkt und entfernt sich damit von diesem. Das zweite (elektrostatisch ausgebildete) Ablenksystem lenkt den Sekundärkorpuskelstrahl nun noch zusätzlich in die Richtung ab, aus der der Primärkorpuskelstrahl in diese Ablenkeinrichtung einläuft, so daß sich eine insgesamt noch größere Trennung ergibt. Bevorzugt ist vor dem Detektor ein Gegenfeldspektrometer angeordnet. Durch die aufgrund der erfindungsgemäßen Anordnung mögliche vollständige räumliche Trennung der Sekundärkorpuskeln können auch weitere Elemente zur Analyse der Sekundärkorpuskeln eingebaut werden, bevorzugt ein Gegenfeldspektrometer.

Nachfolgend wird die Erfindung anhand bevorzugter Ausführungsbeispiele unter Bezugnahme auf die beigefügten Zeichnungen, auf die wegen ihrer Klarheit und Übersichtlichkeit hinsichtlich der Offenbarung ausdrücklich verwiesen wird, noch näher erläutert.

Es zeigen:
- Fig. 1:: Ein erfindungsgemäßes Korpuskularstrahlgerät mit zwei Auslenkeinrichtungen und der erfindungsgemäßen Ablenkeinrichtung.
- Fig. 2:: Das Gerät der Fig. 1, bei dem die erste Auslenkeinrichtung und die Ablenkeinrichtung magnetisch, die zweite Auslenkeinrichtung hingegen elektrostatisch ausgebildet sind, und die dadurch erreichte zusätzliche räumliche Trennung von Sekundär- und Primärkorpuskelstrahl.
- Fig. 3:: Eine Anordnung, bei der die Einrichtungen, die ein schräges Zulaufen des Primärstrahls auf die optische Achse bewirken, durch Schrägstellen der Quelle und eines Teils der nachfolgenden optischen Einrichtungen verwirklicht sind.

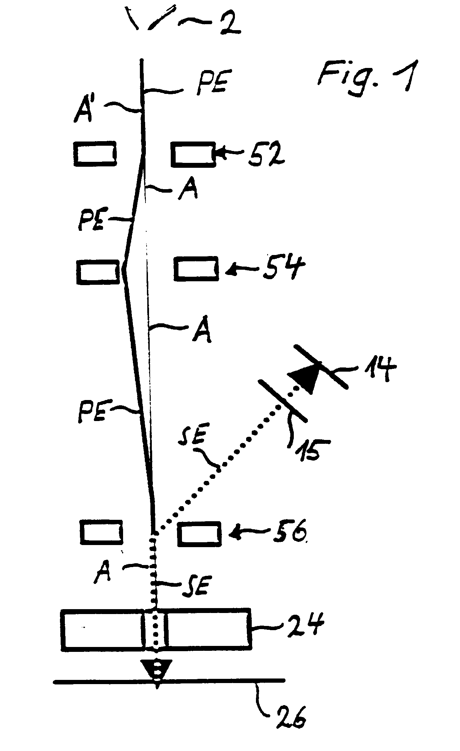

In Fig. 1 wird der Primärkorpuskelstrahl auf der optischen Achse A aus der unter dem Bezugszeichen 2 zusammengefaßten Quelle mit nachfolgender Teilchenoptik (z.B. Kathode, Wehnelt-Elektrode, Absaugelektrode, Anode und Kondensor) kommend gezeigt.

Die erste Auslenkeinrichtung 52 wirkt magnetisch und/oder elektrostatisch und lenkt den Strahl aus der optischen Achse A aus. Unter "optischer Achse" wird diejenige Achse verstanden (in der Regel durch die optische Achse des Objektivs definiert), der der Primärelektronenstrahl ohne die erfindungsgemäßen Auslenk- und Ablenkeinrichtungen folgen würde. Durch die erste Auslenkeinrichtung 52 wird der Strahl von der optischen Achse weggelenkt und durch die zweite Auslenkeinrichtung, die wiederum magnetisch und/oder elektrostatisch sein kann, zur optischen Achse A zurückgelenkt, auf die er demzufolge schräg zuläuft.

Durch die Ablenkeinrichtung 56 wird der Primärkorpuskel(z.B. -elektronen)strahl PE nun in die optische Achse A zurückgeführt und nimmt nachfolgend den Weg, den er ohne die Auslenkeinrichtungen 52 und 54 genommen hätte.

Der Primärelektronenstrahl wird durch das Objektiv 24 geführt und trifft in bekannter Weise auf die Probe 26 auf. Beim Rasterelektronenmikroskop sind zusätzliche Rastereinrichtungen vorgesehen, die hier nicht dargestellt sind.

Durch das Auftreffen des Primärkorpuskelstrahls auf die Probe 26 werden Sekundärkorpuskeln, zum Beispiel Sekundärelektronen oder rückgestreute Elektronen ausgelöst, die durch geeignete Einrichtungen von der Probe weg in Richtung des Objektives beschleunigt werden und vom Objektiv gebündelt werden.

Die im Bereich der optischen Achse A liegenden Sekundärpartikel treten durch die hier als magnetische Einrichtung ausgebildete Auslenkeinrichtung 56 hindurch und werden nach dem Lorentz-Kraftgesetz in den zum Halbraum der Primärelektronen komplementären Halbraum abgelenkt, in dem sich der Detektor 14 entsprechend so angeordnet befindet, daß die Sekundärkorpuskeln auf ihn auftreffen. Durch die erfindungsgemäße Anordnung ist es möglich, z. B. noch ein mit 15 bezeichnetes Gegenfeldspektrometer anzuordnen.

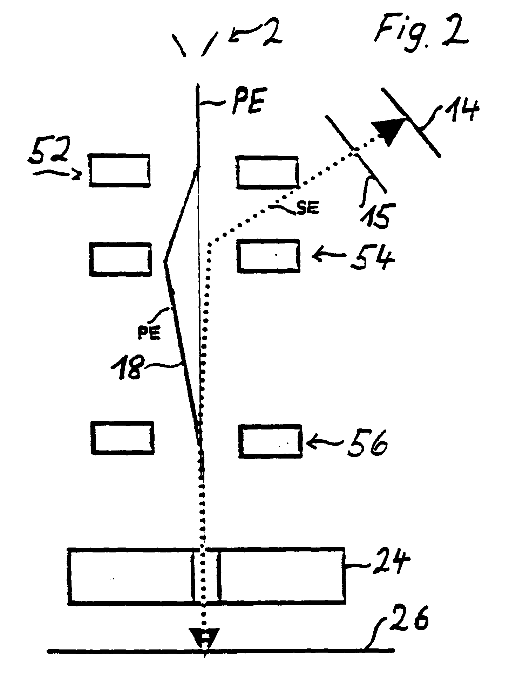

In der in Fig. 2 gezeigten Ausführungsform ist erfindungsgemäß die erste Auslenkeinrichtung 52 magnetisch ausgebildet und die zweite Auslenkeinrichtung 54 elektrostatisch, während hingegen die Ablenkeinrichtung 56 wiederum als magnetische Ablenkeinrichtung ausgebildet ist.

Dadurch ergibt sich der in Fig. 2 dargestellte Verlauf des Primärelektronen- und des Sekundärelektronenstrahles. Es ist anzumerken, daß in den Figuren die radialen Dimensionen und damit die Strahlablenkwinkel zur Verdeutlichung übertrieben groß dargestellt sind.

Darüberhinaus sind, ohne Einschränkung der erfindungsgemäßen Ansprüche, die effektiven Strahlablenkungen der Einfachheit halber durch Knicke angedeutet.

In allen drei Figuren wird außerdem das gleiche Ladungsvorzeichen bei Primär- und Sekundärkorpuskeln angenommen.

In dieser Ausführungsform ist der Detektor 14 und das schon bei Fig. 1 erwähnte Gegenfeldspektrometer 15 oberhalb der zweiten Auslenkeinrichtung, wie dargestellt, angeordnet.

Die übrigen Verhältnisse entsprechen denen der Fig. 1 und werden hier nicht erneut erläutert.

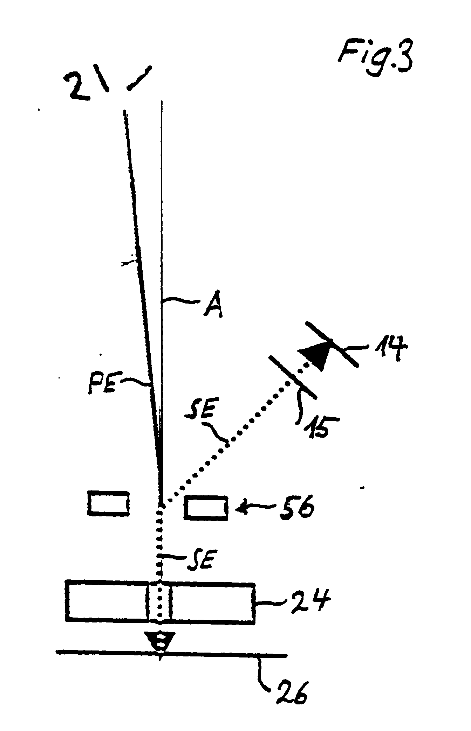

In der Ausführungsform der Fig. 3, in der gleiche Bezugszeichen gleiche oder entsprechende Teile bezeichnen, ist der in Fig. 2 mit 18 bezeichnete Strahlabschnitt durch entsprechende Schrägstellung der unter dem Bezugszeichen 2 zusammengefaßten Einheiten sozusagen nach hinten verlängert, wodurch die Auslenkeinrichtungen 52 und 54 fortgelassen werden können. Dies kann in Einzelfällen eine weniger gute optische Abbildung ergeben, da die Korrekturmöglichkeiten durch die Auslenkeinrichtungen 52 und 54 fehlen, stellt das Grundprinzip der Erfindung jedoch um so reiner dar.

## Patentansprüche

1. Korpuskularstrahlgerät (1) mit
einer Quelle (2) zur Erzeugung der Primärkorpuskeln im Primärstrahl (PE),
einer Probe (26), auf die der Strahl der Primärkorpuskeln, in einer Richtung, unter Erzeugung von Sekundärkorpuskeln (SE), auftrifft,
einer Teilchenoptik (24), um Korpuskeln von der Quelle (2) auf die Probe (26) zu lenken, und
einem außerhalb des Strahlenganges für die Primärkorpuskeln angeordneten Detektor (14) für Sekundärkorpuskeln (SE) von der Probe (26),
**gekennzeichnet durch**
Einrichtungen (52, 54), derart, daß der Primärstrahl (PE) schräg auf die optische Achse (A) zuläuft, und
eine Ablenkeinrichtung (56) unterhalb des Detektors (14) zum Ein- bzw. Rückführen des Primärstrahls (PE) in die optische Achse (A).

2. Korpuskularstrahlgerät nach Anspruch 1, dadurch gekennzeichnet, daß die Einrichtungen durch eine entsprechende Schrägstellung der Quelle (2) und der Teilchenoptik vor der Ablenkeinrichtung (56) verwirklicht sind.

3. Korpuskularstrahlgerät nach Anspruch 1, gekennzeichnet dadurch,
daß die Strahlrichtung zumindest eines Teils des Primärkorpuskelstrahls vor der Ablenkeinrichtung (56) parallelversetzt zur optischen Achse (A) verläuft,
und durch
eine Auslenkeinrichtung (54) zum Auslenken des Primärstrahls aus dieser Strahlrichtung schräg auf die optischen Achse (A).

4. Korpuskularstrahlgerät nach Anspruch 1, dadurch gekennzeichnet,
daß die Richtung (A') des Primärstrahls aus der Quelle (2) im Wesentlichen in der optischen Achse (A) liegt,
und
daß die Einrichtungen eine erste Auslenkeinrichtung (52), zum Auslenken des Primärstrahls (PE) aus der optischen Achse (A, A'), und eine zweite Auslenkeinrichtung (54), zum Rücklenken des Primärstrahls (PE) in Richtung der optischen Achse (A,A'), aufweisen.

5. Korpuskularstrahlgerät nach Anspruch 3 oder 4, dadurch gekennzeichnet, daß die (erste) Auslenkeinrichtung (52) und/oder (zweite) Auslenkeinrichtung (54) elektrostatisch wirkt.

6. Korpuskularstrahlgerät nach einem der Ansprüche 3 bis 5, dadurch gekennzeichnet, daß die (erste) Auslenkeinrichtung (52) und/oder (zweite) Auslenkeinrichtung (54) magnetisch wirkt.

7. Korpuskularstrahlgerät nach einem der Ansprüche 1 bis 6, dadurch gekennzeichnet, daß die Ablenkeinrichtung (56) magnetisch und/oder elektrostatisch wirkt.

8. Korpuskularstrahlgerät nach einem der vorhergehenden Ansprüche, dadurch gekennzeichnet, daß die erste Auslenkeinrichtung (52) magnetisch, die zweite Auslenkeinrichtung (54) elektrostatisch und die Ablenkeinrichtung (56) als magnetische Ablenkeinrichtung ausgebildet ist, wobei der Detektor (14) für die Sekundärkorpuskeln (SE) oberhalb der zweiten (54) Auslenkeinrichtung liegt.

9. Korpuskularstrahlgerät nach einem der vorhergehenden Ansprüche, dadurch gekennzeichnet, daß
vor dem Detektor (14) ein Gegenfeldspektrometer (15) angeordnet ist.
